# EUROPEAN PATENT SPECIFICATION

(11) **EP 0 456 398 B1**
(45) Date of publication and mention of the grant of the patent: **19.07.1995**
(21) Application number: 91303870.9
(22) Date of filing: 29.04.1991
(51) Int. Cl.: H05K 7/20, H05K 5/00

(54) **Cooling of electronic equipment cabinets**
Kühlung von Schränken mit elektronischen Geräten
Refroidissement des armoires d'équipement électronique

(30) Priority: 04.05.1990 US 519050
(43) Date of publication of application: 13.11.1991
(73) Proprietor: AT&T Corp., New York, NY 10013-2412 (US)
(72) Inventor: Bainbridge, Gary Dean, Sparta, New Jersey 07871 (US); Palaszewski, Stephen John, Chester, New Jersey 07930 (US); Sipos, Attila, Montville, New Jersey 07045 (US)
(74) Representative: Johnston, Kenneth Graham

(56) References cited:
- EP-A- 0 225 954
- EP-A- 0 312 372
- DD-A- 0 212 871
- US-A- 3 387 648
- US-A- 4 027 206
- US-A- 4 860 163

## Description

### Background of the Invention

This invention relates to cooling of electronic components.

Higher heat densities in electronic equipment caused by the increasing density of integrated circuits and circuit pack configurations, has led to concern regarding the ability of unvented outdoor electronic cabinets to dissipate the heat generated by the electronics. The equipment is usually housed in shelves within an appropriate cabinet and cooled by fans. Fans can be adapted to blow recirculated coolant onto the components through a series of ducts (see, e.g., U.S. -A- 3,387,648). Alternatively, a fan can draw air from outside the cabinet through openings in a wall of the cabinet and direct it over the components (see, e.g., U.S. -A- 4,027,206). Appropriate ducts can also be used to guide the air (see, e.g., U.S. -A- 4,860,163).

Such cooling techniques, while generally adequate, are not necessarily effective in cases where a large number of high density circuit packs must be housed within a fairly small space, as in the case of subscriber loop carrier (SLC®) remote terminal channel banks. Such banks typically include channel units and common units which are each capable of generating up to 10 watts of heat. These circuit packs are mounted vertically with, typically, 28 circuit packs per shelf and 5 shelves per bank. Usually, banks are housed back-to-back in a cabinet with a small space between them.

The present method generally employed to cool unvented cabinets, which is to blow air into the banks, has reached the limit of its effectiveness. Attempts to increase cooling have generally involved use of heat pipes or finned heat exchangers without addressing the optimization of airflow within the cabinet.

### Summary of the Invention

The invention, in accordance with one aspect, is a cabinet comprising:
a fan mounted to said cabinet so as to be capable of drawing air in a vertical direction;
means for providing recirculation of the air in a vertical direction opposite to the direction of air drawn by the fan, said means including a plate member mounted to the inside of a door of said cabinet to form a duct for recirculation of the air adjacent to a surface of said door so as to provide cooling of the air by said surface of the door, the fan being mounted to be capable of blowing air into the duct; and
a plurality of shelves mounted to said cabinet with a side positioned adjacent to said plate member and vertically spaced from said fan;
wherein
a heat exchanging element is mounted to said cabinet and positioned adjacent to a side of said shelves opposite to said door, as defined in claim 1.

In accordance with another aspect, the invention is a cabinet comprising:
a fan mounted to said cabinet so as to be capable of drawing air in a vertical direction;
means mounted to said cabinet for directing the air in an opposite vertical direction; and
a plurality of vertically stacked shelves mounted to the cabinet with one side positioned adjacent to a door for providing access to said shelves;
wherein
a heat exchanging element (30) is mounted to said cabinet and positioned adjacent a side of the shelves opposite to the door in a relationship to the fan so that air which is directed in the opposite vertical direction can be cooled by the heat exchanging element, said heat exchanging element comprising means (32) for drawing air from outside the cabinet through a plurality of compartments (36,37,38) in said element so as to provide a cooling surface (34) for the air in a space adjacent to said surface, as defined in claim 8.

A cabinet in accordance with the preambles of claims 1 and 8 is known from DD-A-212871.

### Brief Description of the Drawing

These and other features of the invention are delineated in detail in the following description. In the drawing:
FIG. 1 is a perspective view of a cabinet including cooling means useful for understanding the invention;
FIG. 2 is a cross-sectional schematic view of the cabinet of FIG. 1 taken along line 2-2;
FIG. 3 is a perspective view of a cabinet including cooling means in accordance with an embodiment of the invention;
FIG. 4 is a cross-sectional schematic view of a portion of the cooling means of FIG. 3 taken along line 4-4; and
FIG. 5 is a cross-sectional schematic view of the cabinet of FIG. 3 taken along line 5-5.

It will be appreciated that, for purposes of illustration, these figures are not necessarily drawn to scale.

### Detailed Description

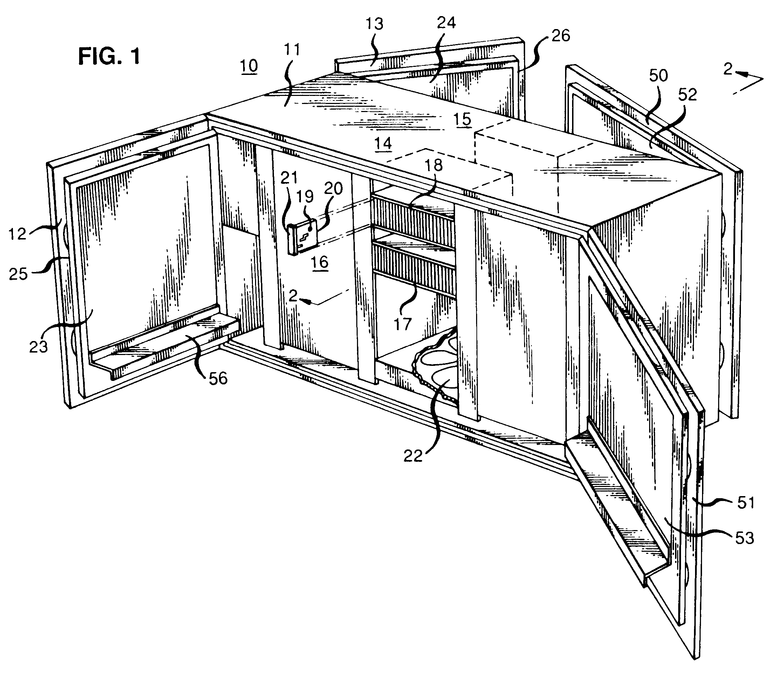

FIG. 1 illustrates a cabinet including cooling means, useful for understanding the invention. The cabinet 10 includes a housing 11 and four doors 12, 13, 50 and 51 hinged on opposite surfaces of the housing. The electronic equipment protected by the housing includes banks 14 and 15 of circuit packs, e.g., 16, mounted in shelves, e.g., 17 and 18. Although not shown, multiple banks can be mounted in a cabinet position, e.g., one above the other. The front of the circuit packs of the two banks 14 and 15 face in opposite directions so as to be accessible by opening different doors. The circuit packs are of a standard type which include components, e.g., 19, formed on a circuit board 20 with a faceplate 21 at the front end for latching the board into the shelf. It will be appreciated that the full number of shelves, as well as other standard components on a remote terminal cabinet, such as protector blocks, power components, and wiring, have been omitted for the sake of clarity in the illustration.

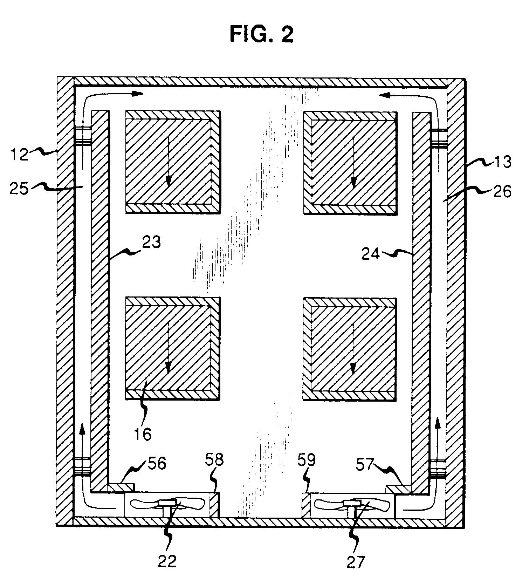

At the bottom of each mounting position in the cabinet is a shelf including a fan (22 and 27 of FIG. 2) mounted so as to draw air down through the spaces between the circuit packs in the bank. The applicants discovered that drawing the air through the bank was more effective than blowing air into the bank in terms of exchanging heat between the air and the heat generating components.

Plates 23, 24, 52 and 53 are mounted in a spaced relationship with each door, 12, 13, 50 and 51, respectively, to provide ducts, e.g., 25 and 26 of doors 12 and 13, for recirculating air as described in more detail below. In this particular example, each plate covered essentially the entire inside surface of its respective door and was mounted to the door by screws and standoffs, but any standard mounting arrangement can be employed. The plates were made of aluminum, but other materials can also be used. The ducts formed between the plates and the doors were approximately 3 cm wide. Each plate also included a horizontal baffle, e.g., 56, mounted to a bottom portion of the plate by standard means.

FIG. 2 is a schematic cross-sectional view along line 2-2 of FIG. 1, with the doors in a closed position, illustrating the flow of air through the cabinet when the fans are turned on. Each rectangular block, e.g., 16, represents a channel bank (typically 5 shelves of circuit packs). As previously mentioned, the fans 22 and 27 draw air down through the banks of circuit packs as indicated by the arrows. The air is then recirculated through the ducts 25 and 26 formed between the plates 23 and 24 and the doors 12 and 13. The ducts prevent the recirculating air from entering the spaces between the faceplates of the circuit packs since the plates extend essentially the entire vertical distance occupied by the circuit packs. While the recirculating air traverses the ducts 25 and 26 it is cooled by the inside surface of the doors 12 and 13 which are made of a good heat conducting material such as aluminum. Thus, by the time the air reaches the top of the cabinet, it is cooled sufficiently so that it can again cool the circuit pack components as it is drawn down through the banks. Air circulation in the vertical space between banks is impeded by use of vertical baffles 58 and 59 attached to the shelves including fans 22 and 27.

Utilizing this technique, it was discovered that the rise in temperature of the hottest circuit packs was lowered by approximately 40 percent over prior schemes which forced air into the channel banks without using a door duct.

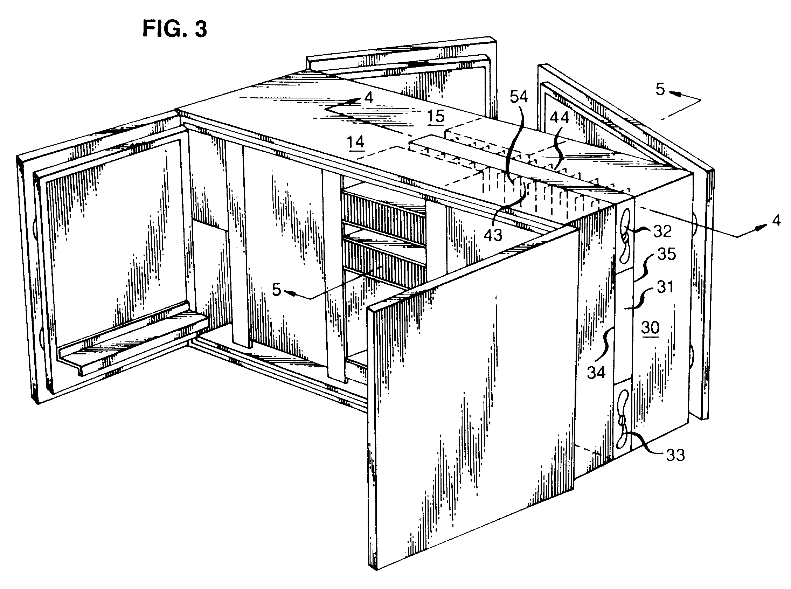

FIG. 3 illustrates a cabinet which further enhances cooling capabilities. The cabinet is essentially the same as that illustrated in FIG. 1 except for the addition of a heat exchange element 30. This element is inserted in a side surface of the housing and extends into the spaces between the banks 14 and 15. This element includes a metal housing 31 providing heat exchanging surfaces adjacent to each bank, and means such as fans 32 and 33 for bringing in air from the outside environment and exhausting the air back to the outside environment. The housing can include metal fins, e.g., 54, for increased heat exchange.

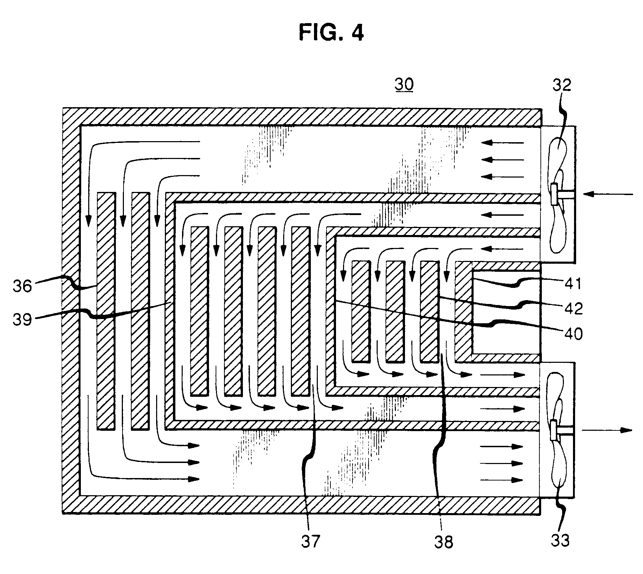

As illustrated by the arrows in the cross-sectional view of the element in FIG. 4, air brought in by fan 32 is circulated through three different main compartments 36-38 formed by U-shaped baffles 39, 40 and 41 as well as secondary compartments formed by vertical plates, e.g., 42. The air is then exhausted through fan 33.

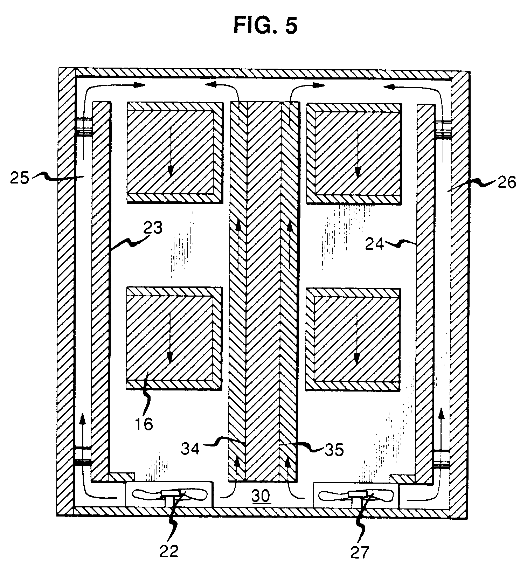

This air flow produces finned heat exchange surfaces 34 and 35 which are utilized for cooling the cabinet as shown in FIG. 5, which is a cross-sectional view along line 5-5 of FIG. 3. Again, air is drawn vertically through the spaces between circuit packs in the banks by the fans 22 and 27. In addition to recirculating through ducts 25 and 26, part of the air is also recirculated in the spaces (43 and 44 of FIG. 3) between the banks which contain finned surfaces 34 and 35 of the heat exchanger element 30. In this example, the spaces 43 and 44 are approximately 3 cm wide. The recirculating air is cooled by the heat exchange surface, 34 and 35 as it traverses upward. (The air is prevented from entering the spaces between circuit packs in its upward path by the usual backplane provided for electrically interconnecting the circuit packs). The cooled air can then be drawn downward again to cool the circuit packs.

Thus, the embodiment shown in FIGS. 3-5 should permit additional heat exchange capabilities over the cabinet of FIGS. 1-2.

## Claims

1. A cabinet (10), comprising:
a fan (22) mounted to said cabinet so as to be capable of drawing air in a vertical direction;
means for providing recirculation of the air in a vertical direction opposite to the direction of air drawn by the fan, said means including a plate member (23) mounted to the inside of a door of said cabinet to form a duct (25) for recirculation of the air adjacent to a surface of said door so as to provide cooling of the air by said surface of the door, the fan being mounted to be capable of blowing air into the duct; and
a plurality of shelves (17,18) mounted to said cabinet with a side positioned adjacent to said plate member and vertically spaced from said fan;
CHARACTERIZED IN THAT
a heat exchanging element (30) is mounted to said cabinet and positioned adjacent to a side of said shelves opposite to said door.

2. The cabinet according to claim 1 further comprising electronic equipment which includes a plurality of circuit packs (16) positioned in said shelves (17,18) mounted to said cabinet so that the air is drawn in vertical spaces between the circuit packs.

3. The cabinet according to claim 2 wherein the electronic equipment includes a plurality of banks (14 and 15) of circuit packs and a plurality of doors (12,13,50, and 51) mounted to said cabinet for providing access to the banks, each of said doors including a plate element (23,24,52 and 53) mounted to an inside surface.

4. The cabinet according to claim 1 wherein the plate member extends a vertical distance essentially co-extensive with said plurality of shelves.

5. The cabinet according to claim 3 wherein the heat exchanging element (30) mounted to said cabinet is positioned in a space between two banks (14 and 15) so that the banks are between the element and the doors.

6. The cabinet according to claim 1 further comprising a baffle mounted at a bottom portion of the plate member (23).

7. The cabinet according to claim 1 further comprising a second plurality of shelves with a side adjacent to another plate member (24) mounted to another door (13) of the cabinet, the heat exchanging element being mounted in a space between the two pluralities of shelves.

8. A cabinet (10) comprising:
a fan (22) mounted to said cabinet so as to be capable of drawing air in a vertical direction;
means mounted to said cabinet for directing the air in an opposite vertical direction; and
a plurality of vertically stacked shelves (e.g., 17 and 18) mounted to the cabinet with one side positioned adjacent to a door for providing access to said shelves;
CHARACTERIZED IN THAT
a heat exchanging element (30) is mounted to said cabinet and positioned adjacent a side of the shelves opposite to the door in a relationship to the fan so that air which is directed in the opposite vertical direction can be cooled by the heat exchanging element, said heat exchanging element comprising means (32) for drawing air from outside the cabinet through a plurality of compartments (36,37,38) in said element so as to provide a cooling surface (34) for the air in a space adjacent to said surface.

9. The cabinet according to claim 8 further comprising a plurality of banks (14,15) of circuit packs (16), positioned within said shelves mounted to said cabinet with the heat exchanging element positioned in a space between the banks.

10. The cabinet according to claim 8 wherein the means for drawing air from outside the cabinet comprises a first fan (32) mounted to said element at an input portion of the compartments, and further comprising an exhaust fan (33) mounted to said element at an output portion of the compartments.

11. The cabinet according to claim 8 wherein the compartments are defined by U-shaped baffles (39,40,41) and vertical plates (42) mounted to said element.

## Patentansprüche

1. Schrank (10), der Mittel zum Kühlen des Schrankinneren aufweist, umfassend:
einen Ventilator (22), der derart befestigt ist, daß er Luft in einer vertikalen Richtung ansaugen kann; und
Mittel, die für die Rückführung der Luft in einer entgegengesetzten vertikalen Richtung sorgen, wobei besagte Mittel ein Plattenglied (23) umfassen, das an der Innenseite einer Tür des besagten Schranks zur Formung eines einer Oberfläche besagter Tür benachbarten Luftkanals (25) zur Rückführung der Luft befestigt ist, damit eine Kühlung der Luft durch besagte Oberfläche der Tür gegeben ist.

2. Schrank nach Anspruch 1, der weiterhin elektronische Geräte umfaßt, die eine Mehrzahl von Schaltungspaketen (16) einschließen, die derart in Rahmen (17, 18) befestigt sind, daß die Luft in vertikalen Räumen zwischen den Schaltungspaketen gezogen wird.

3. Schrank nach Anspruch 2, wobei die elektronischen Geräte eine Mehrzahl von Schaltungspaketstapeln (14 und 15) einschließen und eine Mehrzahl von Türen (12, 13, 50 und 51), die den Zugang zu den Stapeln ermöglichen, wobei besagte Türen jeweils ein an einer inneren Oberfläche befestigtes Plattenelement (23, 24, 52 und 53) umfassen.

4. Schrank nach Anspruch 1, der weiterhin eine Mehrzahl von Rahmen (17, 18) umfaßt, wobei besagte Rahmen oberhalb des besagten Ventilators und dem besagten Plattenglied (23) benachbart angeordnet sind.

5. Schrank nach Anspruch 4, wobei das Plattenglied sich in einem vertikalen Abstand erstreckt, der im wesentlichen die gleiche Erstreckung hat wie die besagte Mehrzahl von Rahmen.

6. Schrank nach Anspruch 3, der weiterhin ein Wärmetauscherelement (30) umfaßt, das in einem Raum zwischen zwei Stapeln (14 und 15) angeordnet ist.

7. Schrank nach Anspruch 1, der weiterhin ein an einem Bodenabschnitt des Plattenglieds (23) befestigtes Windleitblech (56) umfaßt.

8. Schrank (10), der Mittel zum Kühlen des Schrankinneren aufweist, umfassend:
einen Ventilator (22), der derart befestigt ist, daß er Luft in einer vertikalen Richtung ansaugen kann und die Luft in eine entgegengesetzte vertikale Richtung lenken kann; und
ein Wärmetauscherelement (30), das in bezug auf den Ventilator derart befestigt ist, daß die in die entgegengesetzte vertikale Richtung geleitete Luft von dem Wärmetauscherelement gekühlt werden kann, wobei besagtes Wärmetauscherelement Mittel (32) zum Ansaugen von Luft von außerhalb des Schranks durch eine Mehrzahl von Teilräumen (36, 37, 38) in besagtem Element umfaßt, damit in einem der besagten Oberfläche benachbarten Raum eine Kühlfläche (34) für die Luft gegeben ist.

9. Schrank nach Anspruch 8, der weiterhin eine Mehrzahl von Stapeln (14 und 15) von Schaltungspaketen (16) umfaßt, wobei das Wärmetauscherelement in einem Raum zwischen den Stapeln angeordnet ist.

10. Schrank nach Anspruch 8, wobei die Mittel zum Ansaugen von Luft von außerhalb des Schranks einen ersten in einem Einlaßabschnitt des Teilraums befestigten Ventilator (32) und weiterhin einen in einem Auslaßabschnitt des Teilraums befestigten Abluftventilator (33) umfassen.

11. Schrank nach Anspruch 8, wobei die Teilräume von U-förmigen Windleitblechen (39, 40, 41) und vertikalen Platten (42) definiert sind.

## Revendications

1. Armoire (10), comportant des moyens pour refroidir l'intérieur de l'armoire comprenant:
un ventilateur (22) monté de manière à pouvoir aspirer de l'air dans une direction verticale; et
un moyen pour assurer la recirculation de l'air dans une direction verticale opposée, ledit moyen comportant un organe de type plaque (23) monté sur l'intérieur d'une porte de ladite armoire pour former un conduit (25) pour recirculer l'air adjacent à une surface de ladite porte, de manière à assurer le refroidissement de l'air par ladite surface de la porte.

2. Armoire selon la revendication 1, comprenant en outre un équipement électronique qui comporte une pluralité de boîtiers de circuits intégrés (16) montés en étagères (17, 18) de sorte que l'air soit aspiré dans les espaces verticaux entre les boîtiers de circuits intégrés.

3. Armoire selon la revendication 2, dans laquelle l'équipement électronique comporte une pluralité de banques (14 et 15) de boîtiers de circuits intégrés et une pluralité de portes (12, 13, 50 et 51) pour permettre l'accès aux banques, chacune desdites portes comportant un élément de type plaque (23, 24, 52 et 53) monté sur une surface intérieure.

4. Armoire selon la revendication 1, comprenant en outre une pluralité d'étagères (17, 18), lesdites étagères étant positionnées au-dessus dudit ventilateur et adjacentes audit organe de type plaque (23).

5. Armoire selon la revendication 4, dans laquelle l'organe de type plaque s'étend sur une distance verticale essentiellement sur toute l'étendue de ladite pluralité d'étagères.

6. Armoire selon la revendication 3, comprenant en outre un élément échangeur de chaleur (30) positionné dans un espace entre deux banques (14 et 15).

7. Armoire selon la revendication 1, comprenant en outre une chicane (56) montée dans une portion inférieure de l'organe de type plaque (23).

8. Armoire (10), comportant des moyens pour refroidir l'intérieur de l'armoire comprenant:
un ventilateur (22) monté de manière à pouvoir aspirer de l'air dans une direction verticale; et
un élément échangeur de chaleur (30) monté en relation avec le ventilateur de sorte que l'air qui est dirigé dans la direction verticale opposée puisse être refroidi par l'élément échangeur de chaleur, ledit élément échangeur de chaleur comprenant un moyen (32) pour aspirer de l'air depuis l'extérieur de l'armoire, par une pluralité de compartiments (36, 37, 38) dans ledit élément de manière à fournir une surface de refroidissement (34) de l'air dans un espace adjacent à ladite surface.

9. Armoire selon la revendication 8, comprenant en outre une pluralité de banques (14 et 15) de boîtiers de circuits intégrés (16), l'élément échangeur de chaleur étant positionné dans un espace entre les banques.

10. Armoire selon la revendication 8, dans laquelle le moyen d'aspiration de l'air depuis l'extérieur de l'armoire comprend un premier ventilateur (32) monté à une portion d'entrée des compartiments, et comprend en outre un ventilateur aspirant (33) monté à une portion de sortie des compartiments.

11. Armoire selon la revendication 8, dans laquelle les compartiments sont définis par des chicanes en forme de U (39, 40, 41) et des plaques verticales (42).
